# EUROPEAN PATENT APPLICATION

(11) **EP 4 071 803 A1**
(43) Date of publication of application: **12.10.2022**
(21) Application number: 22165514.5
(22) Date of filing: 30.03.2022
(51) Int. Cl.: H01L 23/495

(54) **GRID ARRAY TYPE LEAD FRAME PACKAGE**

(30) Priority: 07.04.2021 US 202163171639 P; 29.03.2022 US 202217706620
(71) Applicant: MEDIATEK INC., Hsin-Chu 300 (TW)
(72) Inventor: CHANG, Chu-Chia, Hsinchu City 30078 (TW); HSU, Wei-Lun, Hsinchu City 30078 (TW)
(74) Representative: Hoefer & Partner Patentanwälte mbB

(57) **Abstract**

A grid array type lead frame package (1) includes a lead frame (20) having a plurality of bonding fingers (201) projecting inwardly from a periphery of the lead frame (20); a semiconductor device (10) mounted on inner ends (201e) of the bonding fingers (201), wherein the semiconductor device (10) comprises an active surface (10a) and a plurality of input/output, I/O, pads (101) disposed on the active surface (10a); a plurality of bonding wires (301) extending between the I/O pads (101) and the bonding fingers (201) for transmitting signals from or to the semiconductor device (10); a molding compound (40) at least partially encapsulating the semiconductor device (10), the bonding wires (301), and the bonding fingers (201); and a solder mask layer (50) attached to a bottom surface (40b) of the molding compound (40) and a bottom surface (201b) of each of the bonding fingers (201).

## Description

### Cross Reference to Related Applications

This application claims priorities from U.S. provisional application No. 63/171,639 filed on April 7, 2021, the disclosure of which is included in its entirety herein by reference.

### Background

The present disclosure relates generally to the field of semiconductor packaging. More particularly, the present disclosure relates to a grid array type lead frame package.

As known in the art, ball grid array (BGA) semiconductor packages utilize as input and output ends a plurality of solder balls mounted at the bottom of a substrate. Not only can the BGA semiconductor package accommodate more numbers of input and output signals, but can be smaller in size than the quad flat semiconductor package.

However, one drawback of the BGA package is that the chip carrier substrate with bismaleimide triazine (BT) resin used as substrate material is expensive and the reliability is not satisfactory.

### Summary

One object of the present invention is to provide a three-dimensional (3D) solder ball pad, an improved interconnection structure, and semiconductor package using the same, in order to solve the above-mentioned prior art problems or shortcomings. A semiconductor package and a method for forming a semiconductor package according to the invention are defined in the independent claims. The dependent claims define preferred embodiments thereof.

One aspect of the disclosure provides a semiconductor package, preferably a grid array type lead frame package, including a lead frame comprising a plurality of bonding fingers projecting inwardly from a periphery of the lead frame; a semiconductor device mounted on inner ends of the bonding fingers, wherein the semiconductor device comprises an active surface and a plurality of input/output (I/O) pads disposed on the active surface; a plurality of bonding wires extending between the I/O pads and the bonding fingers for transmitting signals from or to the semiconductor device; a molding compound at least partially encapsulating the semiconductor device, the bonding wires, and the bonding fingers; and a solder mask layer attached to a bottom surface of the molding compound and a bottom surface of each of the bonding fingers.

Preferably, the semiconductor device is secured to top surfaces of the inner ends of the bonding fingers by using an adhesive film.

Preferably, spacing between the bonding fingers is filled with the molding compound.

Preferably, the bottom surface of the molding compound is flush with the bottom surface of each of the bonding fingers.

Preferably, the solder mask layer comprises solder mask openings, which partially expose the bottom surface of each of the bonding fingers, respectively.

Preferably, a connecting element is disposed on the bottom surface of each of the bonding fingers within the solder mask opening.

Preferably, the connecting element comprises a solder ball or a metal bump.

Another aspect of the disclosure provides a method for forming a semiconductor package, preferably a grid array type lead frame package. A lead frame comprising a plurality of bonding fingers projecting inwardly from a periphery of the lead frame is prepared. A semiconductor device is mounted on inner ends of the bonding fingers, wherein the semiconductor device comprises an active surface and a plurality of input/output (I/O) pads disposed on the active surface. Bonding wires extending between the I/O pads and the bonding fingers for transmitting signals from or to the semiconductor device are formed. The semiconductor device, the bonding wires, and the bonding fingers are at least partially encapsulated with a molding compound. A solder mask layer is formed on a bottom surface of the molding compound and a bottom surface of each of the bonding fingers.

Preferably, the semiconductor device is secured to top surfaces of the inner ends of the bonding fingers by using an adhesive film.

Preferably, spacing between the bonding fingers is filled with the molding compound.

Preferably, the bottom surface of the molding compound is flush with the bottom surface of each of the bonding fingers.

Preferably, the solder mask layer comprises solder mask openings, which partially expose the bottom surface of each of the bonding fingers, respectively.

Preferably, a connecting element is formed on the bottom surface of each of the bonding fingers within the solder mask opening.

Preferably, the connecting element comprises a solder ball or a metal bump.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the invention and are incorporated in and constitute a part of this specification. The drawings illustrate embodiments of the invention and, together with the description, serve to explain the principles of the invention. In the drawings:
FIG. 1 is a schematic, cross-sectional diagram showing an exemplary grid array type lead frame package according to an embodiment of the invention;
FIG. 2 is a perspective side view of the grid array type lead frame package in FIG. 1; and
FIG. 3 to FIG. 8 are schematic diagram showing an exemplary method for fabricating a grid array type lead frame package according to an embodiment of the invention.

### Detailed Description

In the following detailed description of embodiments of the invention, reference is made to the accompanying drawings, which form a part hereof, and in which is shown by way of illustration specific preferred embodiments in which the disclosure may be practiced.

These embodiments are described in sufficient detail to enable those skilled in the art to practice them, and it is to be understood that other embodiments may be utilized and that mechanical, chemical, electrical, and procedural changes may be made without departing from the scope of the present disclosure. The following detailed description is, therefore, not to be taken in a limiting sense, and the scope of embodiments of the present invention is defined only by the appended claims.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

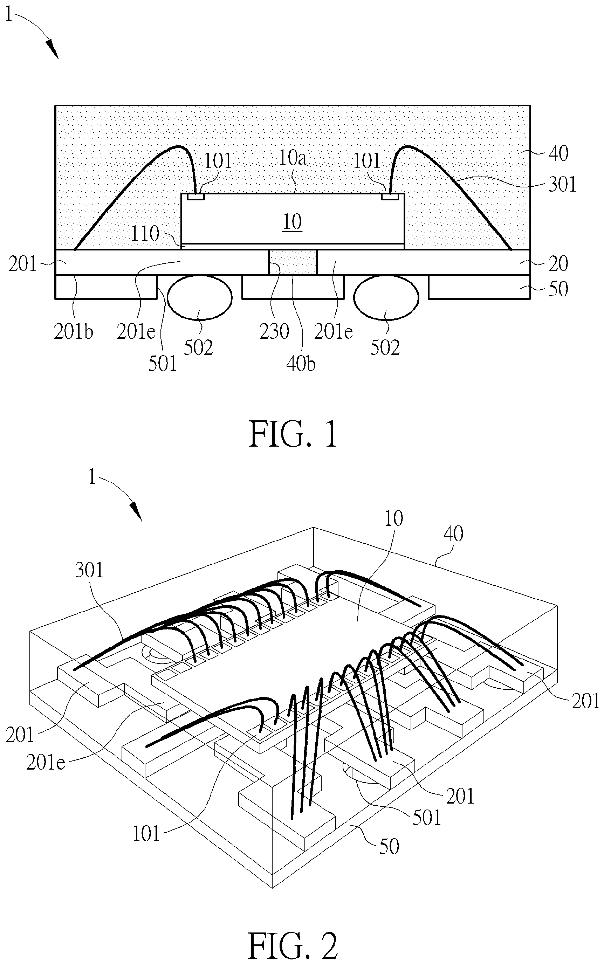

Please refer to FIG. 1 and FIG. 2. FIG. 1 is a schematic, cross-sectional diagram showing an exemplary grid array type lead frame package according to an embodiment of the invention. FIG. 2 is a perspective side view of the grid array type lead frame package in FIG. 1. As shown in FIG. 1 and FIG. 2, the grid array type lead frame package 1 comprises a semiconductor device 10 such as a semiconductor chip or die mounted on a lead frame 20. The lead frame 20 is made from an entire piece of metal such as copper or copper alloys, but is not limited thereto.

Preferably, the lead frame 20 comprises coplanar bonding fingers 201 disposed around the semiconductor device 10. Preferably, the bonding fingers 201 extend inwardly from the outer periphery of the rectangular lead frame 20. Preferably, the semiconductor device 10 may be rested on inner ends 201e of the bonding fingers 201, which are positioned underneath the semiconductor device 10. Preferably, for example, the semiconductor device 10 may be secured to the top surfaces of the inner ends 201e of the bonding fingers 201 by using an adhesive film 110.

Preferably, the semiconductor device 10 comprises an active surface 10a facing upwardly. Preferably, a plurality of input/output (I/O) pads 101 is disposed on the active surface 10a. Preferably, bonding wires 301 such as copper wires or gold wires extend between the I/O pads 101 and the bonding fingers 201 for transmitting signals from or to the semiconductor device 10. Preferably, the semiconductor device 10, the bonding wires 301, and the bonding fingers 201 are at least partially encapsulated by a molding compound 40. Preferably, the spacing 230 between the bonding fingers 201 is also filled with the molding compound 40. Preferably, a bottom surface 40b of the molding compound 40 is flush with a bottom surface 201b of each of the bonding fingers 201.

Preferably, the grid array type lead frame package 1 further comprises a solder mask layer 50 attached to the coplanar bottom surface 40b of the molding compound 40 and the bottom surface 201b of each of the bonding fingers 201. Preferably, the solder mask layer 50 comprises a plurality of solder mask openings 501, which partially expose the bottom surface 201b of each of the bonding fingers 201, respectively. Preferably, a connecting element 502 such as a solder ball or a metal bump may be disposed on the exposed bottom surface 201b of each of the bonding fingers 201within the solder mask opening 501 for further connection with an external circuit.

Preferably, a surface layer (not shown) may be provided on the expose the bottom surface 201b of each of the bonding fingers 201. Further, it is understood that the bonding fingers 201 may be treated by plating or depositing solderable materials such as nickel and gold.

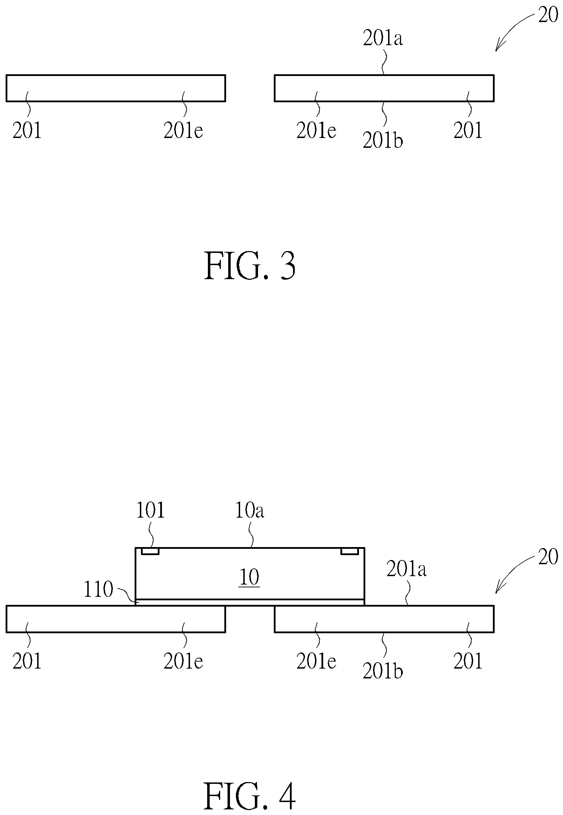

FIG. 3 to FIG. 8 are schematic diagram showing an exemplary method for fabricating a grid array type lead frame package according to an embodiment of the invention. As shown in FIG. 3, a lead frame 20 is provided. The lead frame 20 comprises a plurality of bonding fingers 201 projecting inwardly from the periphery of the rectangular shaped lead frame 20. Preferably, the inner ends 201e of the bonding fingers 201 may be used as mechanical support for a semiconductor chip or die to be mounted on the lead frame 20.

As shown in FIG. 4, a semiconductor device 10 such as a semiconductor chip or die is secured onto the inner ends 201e of the bonding fingers 201 by using an adhesive film 110. Preferably, the semiconductor device 10 comprises an active surface 10a facing upwardly. Preferably, a plurality of I/O pads 101 is disposed on the active surface 10a. Preferably, at this point, the adhesive film 110 may be partially exposed through the gaps between the bonding fingers 201.

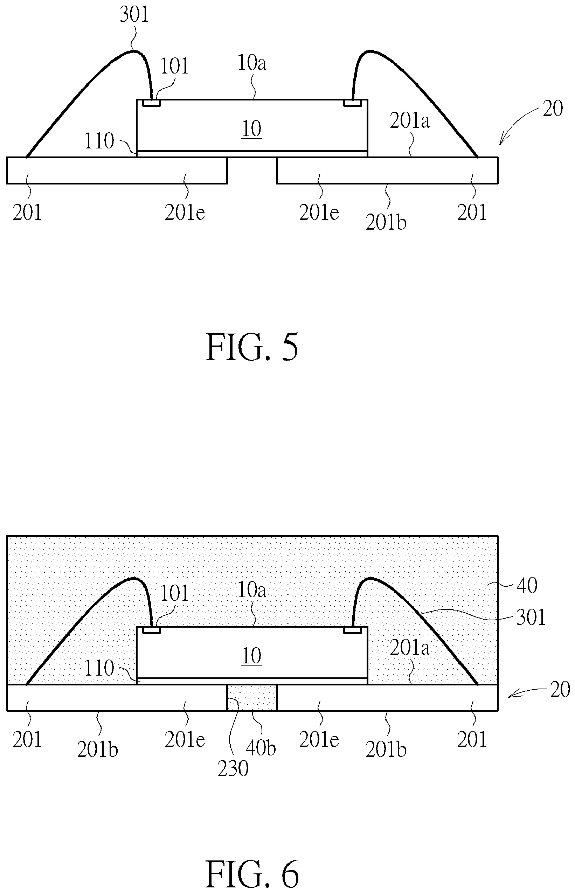

As shown in FIG. 5, bonding wires 301 such as copper wires or gold wires are provided between the I/O pads 101 and the bonding fingers 201 for transmitting signals from or to the semiconductor device 10.

As shown in FIG. 6, a molding process is performed. The semiconductor device 10, the bonding wires 301, and the bonding fingers 201 are at least partially encapsulated by a molding compound 40. Preferably, the spacing 230 between the bonding fingers 201 is also filled with the molding compound 40. Preferably, a bottom surface 40b of the molding compound 40 is flush with a bottom surface 201b of each of the bonding fingers 201.

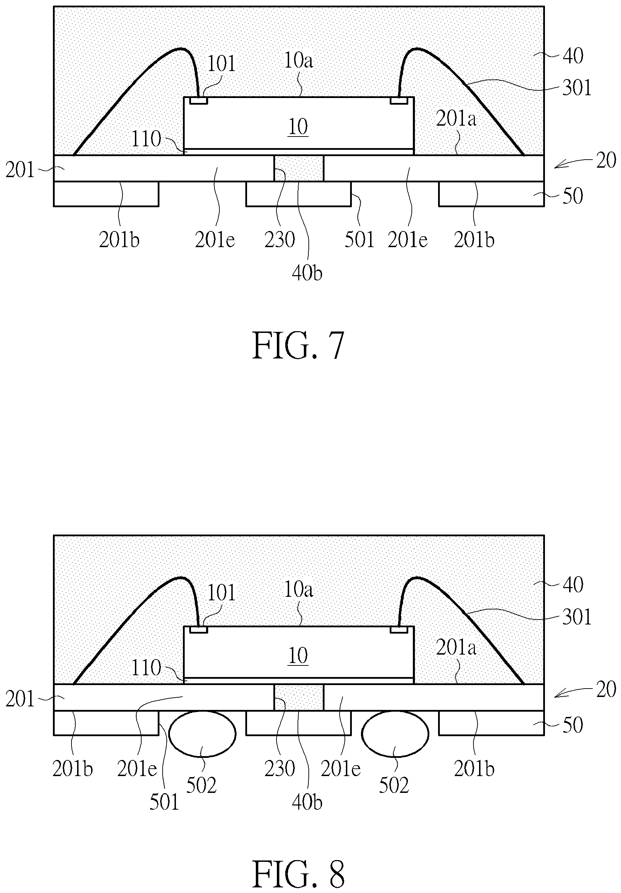

As shown in FIG. 7, a solder mask layer 50 is then attached to the coplanar bottom surface 40b of the molding compound 40 and the bottom surface 201b of each of the bonding fingers 201. Preferably, the solder mask layer 50 comprises a plurality of solder mask openings 501, which partially expose the bottom surface 201b of each of the bonding fingers 201, respectively. Preferably, the solder mask openings 501 may be formed by using a lithographic process and an etching process.

As shown in FIG. 8, a connecting element 502 such as a solder ball or a metal bump may be disposed on the exposed bottom surface 201b of each of the bonding fingers 201within the solder mask opening 501 for further connection with an external circuit.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A semiconductor package (1), comprising:
a lead frame (20) comprising a plurality of bonding fingers (201) projecting inwardly from a periphery of the lead frame (20);
a semiconductor device (10) mounted on inner ends (201e) of the bonding fingers (201), wherein the semiconductor device (10) comprises an active surface (10a) and a plurality of input/output, in the following also referred to as I/O, pads (101) disposed on the active surface (10a);
a plurality of bonding wires (301) extending between the I/O pads (101) and the bonding fingers (201) for transmitting signals from or to the semiconductor device (10);
a molding compound (40) at least partially encapsulating the semiconductor device (10), the bonding wires (301), and the bonding fingers (201); and
a solder mask layer (50) attached to a bottom surface (40b) of the molding compound (40) and a bottom surface (201b) of each of the bonding fingers (201).

2. A method for forming a semiconductor package (1), comprising:
providing a lead frame (20) comprising a plurality of bonding fingers (201) projecting inwardly from a periphery of the lead frame (20);
mounting a semiconductor device (10) on inner ends (201e) of the bonding fingers (201), wherein the semiconductor device (10) comprises an active surface (10a) and a plurality of input/output, in the following also referred to as I/O, pads (101) disposed on the active surface (10a);
forming bonding wires (301) extending between the I/O pads (101) and the bonding fingers (201) for transmitting signals from or to the semiconductor device (10);
at least partially encapsulating the semiconductor device (10), the bonding wires (301), and the bonding fingers (201) with a molding compound (40); and
forming a solder mask layer (50) on a bottom surface (40b) of the molding compound (40) and a bottom surface (201b) of each of the bonding fingers (201).

3. The semiconductor package (1) according to claim 1, or the method according to claim 2, wherein the semiconductor device (10) is secured to top surfaces of the inner ends (201e) of the bonding fingers by using an adhesive film (110).

4. The semiconductor package (1) according to claim 1 or 3, or the method according to claim 2 or 3, wherein spacing (230) between the bonding fingers (201) is filled with the molding compound (40).

5. The semiconductor package (1) according to claim 1, 3 or 4, or the method according to any one of claims 2 to 4, wherein the bottom surface (40b) of the molding compound (40) is flush with the bottom surface (201b) of each of the bonding fingers (201).

6. The semiconductor package (1) according to any one of claims 1 and 3 to 5, or the method according to any one of claims 2 to 5, wherein the solder mask layer (50) comprises solder mask openings (501), which partially expose the bottom surface (201b) of each of the bonding fingers (201), respectively.

7. The semiconductor package (1) according to any one of claims 1 and 3 to 6, wherein a connecting element (502) is disposed on the bottom surface (201b) of each of the bonding fingers (201) within the solder mask opening (501).

8. The method according to any one of claims 2 to 6 further comprising:
forming a connecting element (502) on the bottom surface (201b) of each of the bonding fingers (201) within the solder mask opening (501).

9. The semiconductor package (1) according to claim 7, or the method according to claim 8, wherein the connecting element (502) comprises a solder ball or a metal bump.

10. The semiconductor package (1) according to any one of claims 1, 3 to 7, and 9 is a gride array type lead frame package.

11. The method according to any one of claims 2 to 6, 8, and 9, wherein the semiconductor device (1) is a gride array type lead frame package.
